# EUROPEAN PATENT APPLICATION

(11) **EP 4 192 209 A1**
(43) Date of publication of application: **07.06.2023**
(21) Application number: 22209960.8
(22) Date of filing: 28.11.2022
(51) Int. Cl.: H05K 3/46

(54) **A METHOD OF MANUFACTURING A COMPONENT CARRIER AND A COMPONENT CARRIER**

(30) Priority: 01.12.2021 CN 202111456273
(71) Applicant: At&S (China) Co., Ltd., Shanghai 201108 (CN); AT&S (Chongqing) Company Limited, Chongqing 401133 (CN)
(72) Inventor: Ismail, Ismadi Bin, 93050 Kuching, Sarawak (MY); Tay, Seok Kim, 738202 Singapore (SG); Teoh, Zhen Shi, 76450 Melaka (MY)
(74) Representative: Dilg, Haeusler, Schindelmann Patentanwaltsgesellschaft mbH

(57) **Abstract**

The present application provides a method of manufacturing a component carrier and a component carrier, wherein the method comprises covering a dielectric layer structure (102) by a metal foil (104), forming an electroless metal layer (108) on the metal foil (104), and forming a multi-stage electroplating structure (110) on the electroless metal layer (108).

## Description

The invention relates to a component carrier, and a method of manufacturing a component carrier.

In the context of growing product functionalities of component carriers equipped with one or more electronic components and increasing miniaturization of such components as well as a rising number of components to be mounted on or embedded in the component carriers such as printed circuit boards, increasingly more powerful array-like components or packages having several components are being employed, which have a plurality of contacts or connections, with ever smaller spacing between these contacts. Removal of heat generated by such components and the component carrier itself during operation becomes an increasing issue. At the same time, component carriers shall be mechanically robust and electrically reliable so as to be operable even under harsh conditions.

Properly forming electric traces and other electrically conductive structures within a component carrier is however still a challenge.

There may be a need for a component carrier with electrically conductive structures, such as electric traces, being manufacturable simply and with high reliability.

According to an exemplary embodiment of the invention, a component carrier is provided which comprises a dielectric layer structure covered by a metal foil, an electroless metal layer on the metal foil, and a multi-stage electroplating structure on the electroless metal layer.

According to another exemplary embodiment of the invention, a method of manufacturing a component carrier is provided, wherein the method comprises covering a dielectric layer structure by a metal foil, forming an electroless metal layer on the metal foil, and forming a multi-stage electroplating structure on the electroless metal layer.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. A component carrier may comprise a laminated layer body, such as a laminated layer stack. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "layer structure" may particularly denote a continuous layer, a patterned layer or a plurality of nonconsecutive islands within a common plane.

In the context of the present application, the term "metal foil" may particularly denote a thin sheet (such as a thin sheet of leaf), for example made by rolling or hammering. Foils may be made with malleable leaves, for instance made of copper, aluminum or gold.

In the context of the present application, the term "electroless metal layer" may particularly denote a layer of a metallic material formed by electroless plating or electroless deposition. Electroless plating (which may also be denoted as chemical plating) may refer to a chemical process to create a metal coating, for instance by an autocatalytic chemical reduction of metal cations in a liquid bath.

In the context of the present application, the term "multi-stage electroplating structure" may particularly denote a layered arrangement of two or more layer structures or constituents which are formed on top of one another, wherein each of the layer structures or constituents of the multi-stage electroplating structure is at least partially formed by electroplating, in particular by galvanic deposition. For galvanic deposition or electroplating of one or more layer structures or constituents of the multi-stage electroplating structure, water based solutions or electrolytes may be used which contain metal to be deposited as ions (for example as dissolved metal salts). An electric field between a first electrode (in particular an anode) and a preform of the component carrier to be manufactured as second electrode (in particular a cathode) may force (in particular positively charged) metal ions to move to the second electrode (in particular cathode) where they give up their charge and deposit themselves as metallic material on the surface of the preform of the component carrier, to thereby form a layer structure or constituent of the multi-stage electroplating structure. The multi-stage electroplating structure may be a sequence of a plurality of parallel layers, in particular at least two, more particularly at least three layers.

According to exemplary embodiments of the invention, an electrically conductive connection structure (for instance a horizontally extending trace) of a component carrier (such as a printed circuit board) may be formed by providing a dielectric layer structure (such as a patterned dielectric layer) with a preferably unusually thin metal foil on top thereof. Such a layer stack may be used as a basis for forming a preferably unusually thick electroless metal layer by electroless deposition on the metal foil (and preferably also on a base, such as a layer build up on which the dielectric layer structure is provided). The obtained structure has turned out as a highly appropriate basis for forming a multi-stage electroplating structure thereon, said multi-stage electroplating structure being composed of a plurality of sub-structures each formed by an electroplating process, for instance based on electricity in a galvanic bath. The obtained layer sequence may allow to manufacture a component carrier with electrically conductive traces (or other electrically conductive structures) having excellent properties in terms of reliability and reproducibility. More specifically, the described manufacturing architecture may allow to obtain an electrically conductive trace having a high precision fine line/space aspect ratio, for instance of not more than 20 µm/20 µm. Thus, the described simple manufacturing process may allow to produce fine lines of excellent characteristics and may thereby allow to contribute to a further miniaturization of the component carrier.

Exemplary embodiments of the invention have advantages: An ultra-thin copper foil (as example for the metal foil) may be utilized in combination with an ordinary prepreg (as embodiment for the dielectric structure) in a stack-up in order not to remove strike plating (as part of the formation of the multi-stage electroplating structure) for better reliability. Furthermore, a combination of medium deposition of high build electroless (which may form the above-mentioned electroless plating structure) with an ultra-thin copper foil and strike plating may lead to an optimum base copper thickness (preferably not impacting a 20 µm line shape after etching). Moreover, exemplary embodiments of the invention may reduce the risk of skip plating with an additional layer of flash copper plating as enhancement layer for inter-layer connection. Beyond this, there is substantially no restriction concerning panel thickness when producing component carriers in a horizontal electroless plating line, since no warpage issues occur.

In the following, further exemplary embodiments of the manufacturing method and the component carrier will be explained.

In an embodiment, the method comprises attaching the dielectric layer structure covered by the metal foil as a preformed double layer structure to a base. In the context of the present application, the term "base" may particularly denote a flat or planar sheet-like support body. For instance, the base may be a layer stack, in particular a laminated layer stack or a laminate. Such a laminate may be formed by connecting a plurality of layer structures by the application of mechanical pressure and/or heat. For example, a copper-cladded resin sheet (for instance made of epoxy resin), optionally comprising reinforcing particles (such as glass fibers or glass spheres, as in prepreg) may be used as a semifinished product to be attached to a base (for instance a layer stack). This promotes a quick and simple manufacturing process.

In an embodiment, the method comprises forming the electroless metal layer by a chemical process. For example, the electroless metal layer may be a layer formed by chemical copper. Such an approach has turned out to provide significantly better results as compared to an alternative in which the electroless metal layer is formed by sputtering, in particular physical vapor deposition (PVD).

In an embodiment, the method comprises forming the multi-stage electroplating structure by flash plating (as a first electroplating stage) followed by pattern plating (as at least one additional electroplating stage). Flash plating may denote an electroplating process by which a preform of the component carrier to be manufactured (for instance a panel) may be put in a chemical bath for galvanic deposition of a flash plating layer of the multi-stage electroplating structure. During flash plating, the current density of the electroplating process may be smaller, preferably significantly smaller, than during subsequent pattern plating. Pattern plating may denote a subsequent electroplating process during which a (preferably patterned) metal layer is deposited on the underlying flash plating layer (which may be partially covered with a dielectric material for preventing electroplating during pattern plating selectively on the dielectric material).

In an embodiment, the method comprises patterning the dielectric layer structure covered by the metal foil, in particular to expose the above-mentioned base (on which the dielectric layer structure is formed) by a laser via in the patterned dielectric layer structure covered by the metal foil. In a corresponding embodiment of the component carrier, the dielectric layer structure covered by the metal foil may be patterned, in particular to expose the base by a laser via in the patterned dielectric layer structure covered by the metal foil. Hence, a double layer composed of dielectric layer structure and metal foil may be subjected to laser drilling (or mechanically drilling or etching) for exposing part of the base (such as a layer stack), in particular for forming an electrically conductive trace on the patterned dielectric layer structure and/or a metal filled via in a gap. For instance, a blind hole (for instance an elongate blind hole) may be formed for defining a shape and/or an outline of an electrically conductive structure to be formed, for instance a trace, a pad or a via. Such a blind hole may have an open top and a closed bottom. Preferably, the blind hole may be formed as a laser blind hole, i.e. may be formed by a laser process.

In an embodiment, the method comprises forming at least one of the electroless metal layer and the multi-stage electroplating structure (partially or entirely) in a horizontal plating line. In a horizontal plating line, a plate-shaped preform of a component carrier to be manufactured (for instance a panel comprising a plurality of still integrally connected preforms of component carriers to be manufactured) is oriented horizontally during the plating process. This may be preferred over a vertical plating line (which may however be possible in other embodiments) for manufacturing component carriers with small thickness and/or demanding requirements in terms of line/space ratio.

In an embodiment, the method comprises structuring the metal foil, the electroless metal layer and the multi-stage electroplating structure together, in particular using a lithographic dry film process. Consequently, the method may comprise forming an opening extending through the multi-stage electroplating structure, the electroless metal layer and the metal foil for exposing the dielectric layer structure. This multi-layer material removal (in particular etching) process may define a limit of a region over which an electrically conductive structure to be formed (for instance a trace, a metal filled via, etc.) extends. For defining a region in the layer stack subject to material removal by etching, the layer stack may be covered for example with a patterned mask (for instance a dry film or other kind of photomask), which may be created by lithography. Thereafter, the patterned mask may be used for selectively etching an exposed portion of the multi-layer structure.

In an embodiment, the method comprises forming a dielectric pattern on a bottom-sided flash plating structure of the multi-stage electroplating structure and forming the dielectric pattern to extend through a top-sided pattern plating structure of the multi-stage electroplating structure. Such a dielectric pattern may be a spatially constricted body of electrically insulating material which locally prevents electroplating due to its presence, since no current can be applied to such a dielectric pattern. Descriptively speaking, the dielectric pattern may cover a surface portion of the flash plating structure and may thereby prevent in a spatially selective way formation of a pattern plating structure of the multi-stage electroplating structure thereon.

In an embodiment, the dielectric layer structure, covered by the metal foil, is formed on only part of a base. Correspondingly, the electroless metal layer may be formed partially on the metal foil and partially on an exposed portion of the base. For instance, the dielectric layer structure and the metal foil may be formed conformally on the entire base, and may then be patterned, for instance by laser processing. Alternatively, patterning may be accomplished by a mechanical process or by etching.

In an embodiment, the dielectric layer structure and the metal foil are patterned, in particular to expose the base by a via in the patterned dielectric layer structure and the patterned metal foil. Such a via may in particular be a laser via formed by laser drilling. For forming such a via, a laser beam may be directed onto the dielectric layer structure. When an ultra-thin metal foil (for example having a thickness of less than 5 µm, preferably of not more than 3 µm, for instance 2 µm or less) is formed on the dielectric layer structure, the laser may also drill through the metal foil for avoiding a separate etching process for patterning the metal foil on the dielectric layer structure. In alternative embodiments, the metal foil may be patterned by etching prior to laser drilling of a via in the dielectric layer structure.

In an embodiment, the via is at least partially filled by part of the electroless metal layer and by part of the multi-stage electroplating structure. Preferably, the entire via is filled with a metal formed partially by electroless plating and partially by electroplating. Consequently, a via filled with electrically conductive material may be obtained.

In an embodiment, the multi-stage electroplating structure has a larger thickness in the via compared to a smaller thickness above the dielectric layer structure. While a flash layer (in particular made of copper) formed by electroplating may have a substantially constant thickness within and outside of the via, a pattern plating structure (in particular made of copper) formed thereafter by electroplating may have a certain thickness outside of the via and may have a larger thickness inside of the via, in particular for completely filling out the via with metal.

In an embodiment, the base comprises a stack comprising at least one electrically conductive layer structure and/or at least one electrically insulating layer structure. Hence, the base may be formed as any desired layer stack, in particular laminated layer stack (i.e. formed by the application of heat and/or pressure).

In an embodiment, the metal foil has a thickness of less than 5 µm, in particular of not more than 3 µm. Highly advantageously, the metal foil may be ultra-thin. This may improve reliability of an obtained trace and may improve the properties of the component carrier by suppressing the tendency of forming an undercut at a bottom of a formed trace. The thickness of the metal foil may be constant.

In an embodiment, the electroless metal layer has a thickness of not more than 2 µm, in particular a thickness in a range from 1 µm to 1.5 µm. Although being quite thin compared to the multi-stage electroplating structure, an electroless metal layer with a thickness in the mentioned range may be considered as remarkably thick in component carrier manufacturing technology. Such a high built electroless layer may be utilized with a medium deposition rate on a thin metal foil (in particular the above-mentioned thin metal foil) which can be produced in a horizontal electroless plating line without capacity impact. The thickness of the electroless metal layer may be constant.

In an embodiment, the multi-stage electroplating structure has a maximum thickness of at least 10 µm, in particular of at least 20 µm. Depending on the desired thickness of the multi-stage electroplating structure, a number of electroplating stages may be adjusted.

In an embodiment, a pattern plating structure of the multi-stage electroplating structure has a thickness of at least 5 times of a thickness of a flash plating structure of the multi-stage electroplating structure. Hence, the vast majority of the metal volume applied by electroplating may be provided by pattern plating, whereas flash plating only contributes with a minor metal volume. The thickness of the flash plating structure may be constant, whereas the thickness of the pattern plating structure may vary over a horizontal extension (for instance may be larger in the laser via than above the dielectric layer structure).

In an embodiment, the metal foil, the electroless metal layer and the multi-stage electroplating structure form an electrically conductive structure with a line/space ratio of not more than 20 µm/20 µm, in particular with a line/space ratio of not more than 15 µm/15 µm. In terms of the line/space ratio, the line may denote a horizontal diameter of a trace. In contrast to this, the space may denote a distance between two adjacent traces. With the described manufacturing architecture of covering a dielectric layer structure with a metal foil, and thereafter forming an electroless metal layer and subsequently a multi-stage electroplating structure, the mentioned extremely demanding line/space ratio of not more than 20 µm/20 µm may be achieved. Further factors which may contribute to an excellent line/space ratio are the ultra-small thickness of the metal foil of preferably not more than 3 µm, the unusually high thickness of the electroless plating layer preferably in a range from 1 µm to 1.5 µm, and the addition of a flash plating stage (or a strike plating stage) during forming the multi-stage electroplating structure. Flash plating or strike plating may lead to a high reliability.

In an embodiment, the electrically conductive structure is a trace. Such a trace may be a horizontally extending electrically conductive line configured for conducting electric signals or electric energy during operation of the component carrier. When high-frequency signals (in particular with a frequency in a range from 100 MHz and 300 GHz) are transported along such a trace, the excellent quality and high degree of structural precision of the mentioned trace may allow a low loss high-frequency signal transmission. Descriptively speaking, the skin effect may allow a high-frequency signal to propagate only through a thin surface skin of the trace, so that an accurately defined geometry of the outline of the trace may be of utmost advantage for low loss high-frequency signal transmission.

In an embodiment, the electrically conductive structure is free of an undercut. The term "undercut" may define a space formed by the removal or absence of material at a lower lateral part of an electrically conductive trace formed on the base of the component carrier. When using an ultra-thin metal foil on a dielectric layer structure as a basis for forming a trace thereon, the undesired phenomenon of a trace undercut may be strongly suppressed. As a result, a high degree of electric reliability, and in particular a proper high-frequency behavior may be achieved.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be embedded in and/or surface mounted on the stack. Such an at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.
Figure 1 illustrates a cross-sectional view of a component carrier according to an exemplary embodiment of the invention.
Figure 2 illustrates a flowchart of a method of manufacturing a component carrier according to an exemplary embodiment of the invention.
Figure 3 to Figure 8 show structures obtained during carrying out a method of manufacturing a component carrier, illustrated in Figure 8, according to an exemplary embodiment of the invention.
Figure 9 to Figure 13 show images with cross-sectional views of portions of component carriers according to exemplary embodiments of the invention.
Figure 14 illustrates a cross-sectional view of a component carrier having traces with small line/space ratio according to an exemplary embodiment of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

Conventionally, a trace of a component carrier may be produced by an SAP (semi additive processing) process flow to obtain a relatively small line/space ratio. During a corresponding manufacturing process, it may be possible to apply a vertical electroless plating process to induce an electroless plating layer on a resin sheet laminate. Such a conventional manufacturing process may involve a risk of skip plating in a electroless plating layer and may cause layer separation or voids in an interior of an electrically conductive structure. Furthermore, such an SAP manufacturing process may be limited to thick cores to prevent panel warpage in a vertical electroless plating tank. Such a conventional approach may also require fixing of a plate or another preform of component carriers in a dedicated frame holder.

According to an exemplary embodiment of the invention, a component carrier (such as a PCB) is provided which comprises a double layer of a dielectric layer structure and a thin metal foil. An electroless metal layer and a multi-stage electroplating structure on the electroless metal layer may be formed subsequently on the double layer (and preferably in a via neighbored to the double layer). This may allow to create a trace of a component carrier with extremely small line/space ratio, with excellent spatial and geometric accuracy and with very small or even no undercut. Advantageously, such a manufacturing architecture may in particular allow to obtain a line/space ratio of 20 µm/20 µm or less thanks to the use of high build electroless plating in combination with an ultra-thin copper foil and due to the use of a horizontal flash copper plating line.

In particular, an exemplary embodiment of the invention provides an mSAP (modified semi additive processing) process flow to produce traces with a line/space ratio of 20 µm/20 µm or less. Advantageously, exemplary embodiments of the invention may utilize high build electroless plating with medium deposition rate on a thin copper foil which can be produced in a horizontal electroless plating line with no capacity impact. In particular, it may be advantageous to utilize an ultra-thin copper foil with a prepreg in a stack-up in order not to remove strike plating for better reliability and to improve a trace width undercut behavior. Beyond this, exemplary embodiments may make it possible to carry out a micro etch process on a flash copper plating layer before dry film lamination and pattern plating to enhance reliability performance. Preferably, a combination of medium deposition of high build electroless with an ultra-thin copper foil and strike plating may lead to an optimum base copper thickness which will not impact a 20 µm line shape after etching. Further advantageously, exemplary embodiments of the invention involve only a low risk of skip plating with an additional layer of flash copper plating as bonding enhancement layer for inter-layer connection. Furthermore, there is substantially no restriction of panel thickness when producing component carriers in a horizontal electroless plating line, since there may be no warpage caused by a frame holder. An exemplary embodiment of the invention may make it possible to produce a 20 µm/20 µm line and space with an mSAP process stack-up with a layer of flash copper plating as secure bonding between an electroless plating layer and an electroplating layer.

Conventional SAP processes capable of producing component carriers with low line/space ratio may require a substantial extra effort for a vertical high build electroless plating line and also the development and execution of complex processes. Apart from the high effort, the capacity of such a conventional manufacturing method may be low and the reliability risk may be high.

By implementing a high build electroless process to a horizontal plating line and by utilizing an ultra-thin copper foil, it may be possible to efficiently utilize mSAP processes for obtaining a low line/space ratio. This may be done with reasonable effort, high capacity and a low reliability risk. Consequently, component carriers with extreme demanding line and space patterning requirements may be produced. Exemplary applications of exemplary embodiments of the invention are component carriers for mobile phones and for modules (in particular comprising a plurality of embedded and/or surface mounted interacting components). Component carriers according to exemplary embodiments of the invention may be manufactured in a compact way.

Exemplary embodiments of the invention may be implemented with a horizontal high build electroless plating process rather than with a vertical high build electroless plating process for reducing the effort in terms of manufacturing component carriers with low line/space ratio. This may allow to manufacture printed circuit boards in mSAP design. In particular, a layer of flash copper may be plated on a component carrier with small line/space ratio around a laser via hole surface area. Hence, a fine line or space capability improvement may be achieved by horizontal high build electroless plating.

A conventional way to produce component carriers with small line/space ratio needs high deposition electroless plating that can only be done in a technically and economically feasible way in a vertical plating line. Assuming theoretically a high build electroless plating stage for an SAP process with horizontal line, due to the high required thickness the speed will be super slow and the process line will be super long. Hence, the involved effort is not effective and not feasible for mass production. In such conventional approaches, no copper foil and strike plating processes are carried out to keep the base copper low in order to achieve a good shape after etching.

In contrast to this, there may be no need for a vertical high build electroless equipment according to exemplary embodiments of the invention. Exemplary embodiments may allow to execute horizontal electroless plating with no capacity impact. Horizontal electroless plating may be preferred, because this may allow to utilize a simple line setup for an mSAP process without sophisticated changes. Furthermore, there may be less space demand, and productivity may be higher. Apart from this, a horizontal line process may be a continuous process with a flood bar closer to the panel surface. Via holes bottom properties may be better. It may also be possible to connect an electroless module directly to an electrolytic plater and perform strike plating in line. A vertical line may normally produce in bulk or - if applied as continuous plating line - may need a large space. In conventional approaches, via bottom behaviour may be poor in a batch process, and such a line cannot be arranged in-line with an electrolytic plater in conventional systems. Furthermore, exemplary embodiments of the invention may keep the copper foil and the strike copper in the stack-up, which may lead to a high reliability.

In contrast to conventional mSAP processes for manufacturing traces of component carriers, exemplary embodiments of the invention may simply require a chemistry change without a fundamental hardware change so that a fine line trace may be manufactured with low effort. In particular the use of a resin-copper-double sheet connected to a layer stack on which a fine line trace is to be formed as well as the execution of an additional flash etching process in terms of electroplating may lead to advantageous properties of a manufactured component carrier. Advantageously, very straight traces without undercut may be obtained.

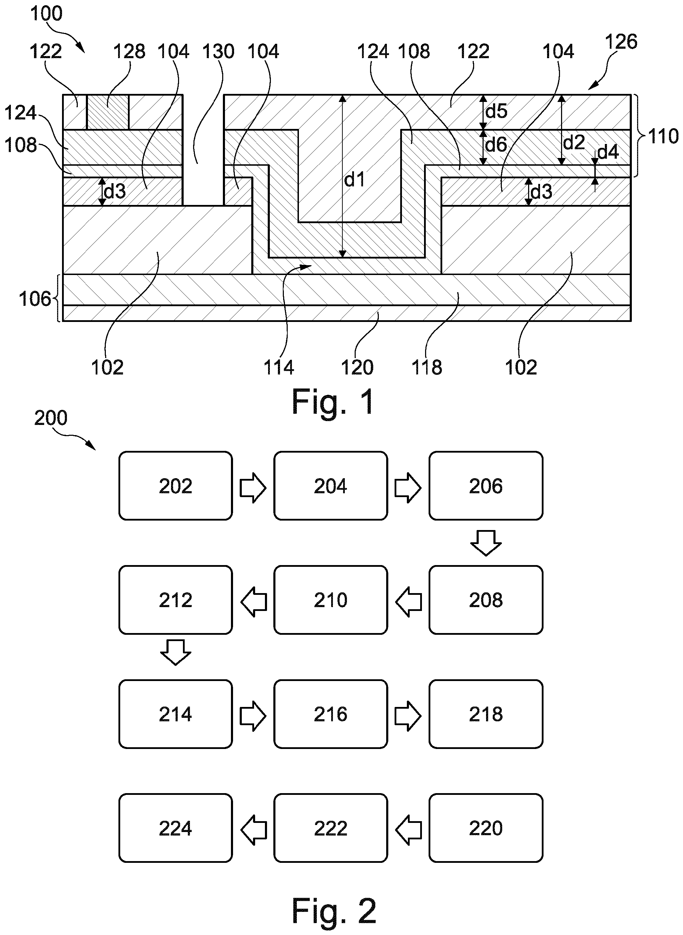

**Figure 1** illustrates a cross-sectional view of a component carrier 100 according to an exemplary embodiment of the invention.

The component carrier 100 according to Figure 1 may be configured as a substantially plate-shaped printed circuit board (PCB). Thus, the component carrier 100 shown in Figure 1 may be highly compact in a vertical direction. More specifically, the component carrier 100 may comprise a base 106 comprising one or more electrically conductive layer structures 118 and/or one or more electrically insulating layer structures 120. Each of the electrically conductive layer structures 118 may comprise a layer section and vertical through connections, for example copper filled vias which may be created by drilling and plating. The electrically insulating layer structure(s) 120 may comprise a respective resin (such as a respective epoxy resin), preferably comprising reinforcing particles therein (for instance glass fibers or glass spheres). For instance, the electrically insulating layer structures 120 may be made of FR4. Thus, the base 106 comprises a laminated layer stack comprising one or more electrically conductive layer structures 118 and one or more electrically insulating layer structures 120.

Again referring to Figure 1, the component carrier 100 comprises a dielectric layer structure 102, covered by a metal foil 104, on at least of part of the base 106. For instance, the dielectric layer structure 102 may be a resin layer (for example may be formed of epoxy resin) or may comprise resin and reinforcing particles (for instance may be formed as prepreg). The metal foil 104 on the dielectric layer structure 102 may be an ultra-thin copper foil having a thickness of for instance 3 µm. The dielectric layer structure 102 and the metal foil 104 may be provided as a common semifinished product, i.e. as a pre-fabricated double layer, such as copper cladded resin. As shown, the mentioned double layer is structured, which is accomplished in the shown embodiment by the formation of a laser via 114 extending through both the dielectric layer structure 102 and the metal foil 104 for exposing a central portion of base 106. Hence, the dielectric layer structure 102 and the metal foil 104 are patterned to thereby expose a portion of the base 106. This is accomplished by creating laser via 114 in the patterned dielectric layer structure 102 covered by the metal foil 104.

Furthermore, an electroless metal layer 108 is formed partially on the metal foil 104 (where present) and partially on the base 106 (where exposed).

Apart from this, a multi-stage electroplating structure 110 is formed on the electroless metal layer 108. The multi-stage electroplating structure 110 is composed of a flash plating structure 124 formed directly on the electroless metal layer 108, and a pattern plating structure 122 formed directly on the flash plating structure 124.

Apart from the laser via 114, the metal foil 104, the electroless metal layer 108, the flash plating structure 124 and the pattern plating structure 122 form a stack of parallel layers. In contrast to this, in the laser via 114 and consequently directly on base 106, the metal layer 104 is absent, electroless metal layer 108 and flash plating structure 124 constitute a substantially U-shaped double layer, and pattern plating structure 122 fills up the rest of the laser via 114. Consequently, the laser via 114 is completely filled by the electroless metal layer 108 and the multi-stage electroplating structure 110.

Next, the thicknesses of the various layer structures shown in Figure 1 will be explained: Inside of the laser via 114, the multi-stage electroplating structure 110 may have a maximum thickness d1 of at least 20 µm, for example 25 µm. Moreover, the multi-stage electroplating structure 110 may have a larger thickness d1 in the laser via 114 compared to a smaller thickness d2 above the dielectric layer structure 102. For example, d2 may be at least 15 µm, for example 20 µm. Advantageously, the metal foil 104 has a thickness d3 of not more than 4 µm, preferably 3 µm. Still referring to Figure 1, the electroless metal layer 108 may have a thickness d4 in a range from 1 µm to 1.5 µm, for example 1.2 µm. What concerns the pattern plating structure 122 of the multi-stage electroplating structure 110, it may have a thickness d5 of more than 5 times of a thickness d6 of a flash plating structure 124 of the multi-stage electroplating structure 110.

Advantageously, the metal foil 104, the electroless metal layer 108 and the multi-stage electroplating structure 110 form an electrically conductive structure 126 with a line/space ratio of not more than 20 µm/20 µm. The created electrically conductive structure 126 may be a trace. Due to the arrangement shown in Figure 1 and as a result of the executed manufacturing methods, the electrically conductive structure 126 is free of an undercut at its bottom side.

Figure 1 shows as well that component carrier 100 comprises a dielectric pattern 128 on top of the flash plating structure 124 and extending through the top-sided pattern plating structure 122 of the multi-stage electroplating structure 110. For instance, dielectric pattern 128 may be a structured dry film.

As shown as well, an opening 130 extends vertically through the multi-stage electroplating structure 110, the electroless metal layer 108 and the metal foil 104 for exposing the dielectric layer structure 102. A corresponding etching process may define a lateral limit of an electrically conductive structure 126 to be created.

Electrically conductive structure 126 embodied as horizontal trace may have an advantageously low line/space ratio of not more than 20 µm/20 µm, preferably of not more than 15 µm/15 µm. An undesired undercut on the bottom side of the metal foil 104 may be reliably prevented. The trace may be created with high spatial accuracy and with a simple manufacturing process. Manufacturability of the component carrier 100 according to Figure 1 using a horizontal electroless plating line may be simple and without capacity impact. The low thickness of the metal foil 104 may lead to a proper reliability. The synergetic combination of the high-thickness electroless metal layer 108 with the formation of the flash plating structure 124 by flash or strike plating may lead to an optimal base copper thickness below pattern plating structure 122, which may promote, in turn, a low line/space ratio. Undesired phenomena such as delamination of the individual layers and warpage of the component carrier 100 as a whole may be reliably prevented. Consequently, there is also substantially no restriction in terms of panel thickness.

A person skilled in the art will understand that the different metal structures of component carrier 100 according to Figure 1 may be distinguished visually when inspecting a cross-sectional image thereof (in particular based on grain boundaries between the various layers).

The component carrier 100 shown in Figure 1 may be manufactured as will be described in the following referring to Figure 2.

**Figure 2** illustrates a flowchart 200 of a method of manufacturing a component carrier 100 according to an exemplary embodiment of the invention.

Referring to a block 202, the method may comprise forming a thin foil layup and executing lamination.

Referring to a block 204, the method may comprise provision of a bond film.

Referring to a block 206, the method may comprise forming a laser via.

Referring to a block 208, the method may comprise removing the bond film.

Referring to a block 210, the method may comprise carrying out a desmear process.

Referring to a block 212, the method may comprise executing high build electroless plating (for instance for forming an electroless plating layer having a thickness of 0.9 µm).

Referring to a block 214, the method may comprise execution of a preclean process and of a dry-film lamination process.

Referring to a block 216, the method may comprise a process of exposing a trace pattern.

Referring to a block 218, the method may comprise a developing process.

Referring to a block 220, the method may comprise pattern plating (for instance at a thickness of 20 µm).

Referring to a block 222, the method may comprise dry-film stripping.

Referring to a block 224, the method may comprise flash etching.

Thus, an exemplary embodiment of the invention may relate to an mSAP process for forming an electrically conductive structure 126 with a line/space ratio of for example 20 µm/20 µm. Such an mSAP process may use a copper foil and a prepreg sheet for providing a buildup layer. Furthermore, such an mSAP process may be based on the provision of a copper foil, a high build electroless structure on top, followed by strike plating. Advantageously, it may be possible to carry out a horizontal electroless plating process for creating a high build electroless plating layer on a copper foil layer. Moreover, a micro etch may be applied on the electroless plating layer before dry film lamination and pattern plating.

It may be preferred to execute a pre-curing process after build up film lamination. Furthermore, bond film provision and bond film removal may be applied before and after laser processing. Furthermore, it may be possible to apply a horizontal high build electroless plating process on each copper foil build layer. Beyond this, a micro etch may be applied on the electroless plating layer before dry film lamination and pattern plating.

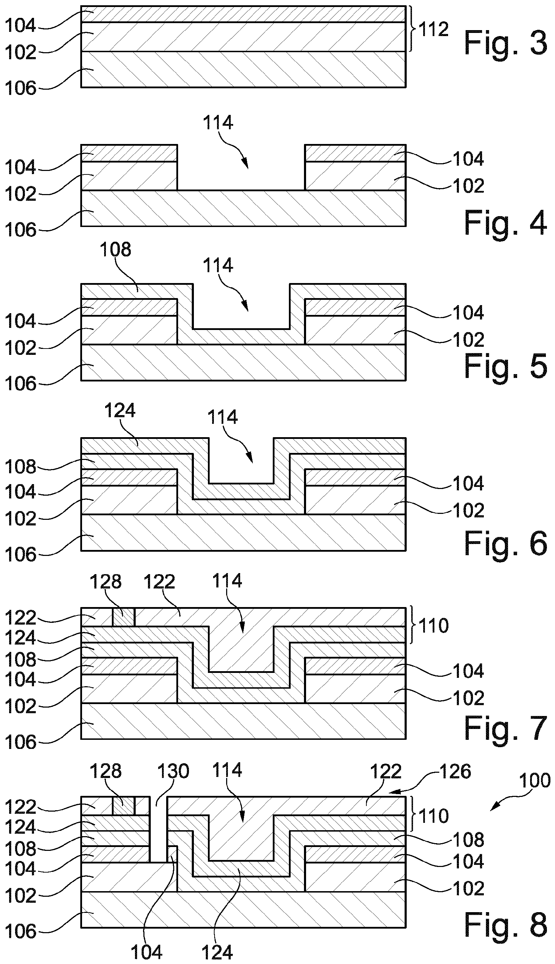

Figure 3 to Figure 8 show structures obtained during carrying out a method of manufacturing a component carrier 100, illustrated in Figure 8, according to an exemplary embodiment of the invention.

Referring to **Figure 3****,** a dielectric layer structure 102 (for example a prepreg sheet having a thickness of 25 µm), covered by metal foil 104 (for example a copper foil), is formed on a base 106. Preferably, the dielectric layer structure 102 covered by the metal foil 104 is attached as a preformed double layer structure to the base 106. Further preferably, the metal foil 104 is very thin, for instance has a vertical thickness of 2 µm.

Referring to **Figure 4****,** the dielectric layer structure 102, covered by the metal foil 104, is patterned by laser drilling. Consequently, a central portion of the base 106 is exposed by forming a laser via 114 extending entirely through the patterned dielectric layer structure 102 and extending entirely through the metal foil 104.

Referring to **Figure 5****,** an electroless metal layer 108 (for example a copper layer) is formed on the metal foil 104 and on an exposed portion of base 106 by electroless plating. Preferably, the electroless metal layer 108 is formed by a chemical process, for instance as chemical copper. The electroless metal layer 108 may be quite thick, for instance may have a thickness of 1.5 µm. Advantageously, the electroless metal layer 108 may be created in a horizontal plating line, i.e. with a corresponding panel being oriented horizontally during the electroless deposition process in an appropriate chemical bath for forming the electroless metal layer 108. Descriptively speaking, the electroless metal layer 108 may cover a region on and around the laser via 114 in order to prepare the shown structure for subsequent flash plating.

Referring to **Figure 6****,** a flash plating structure 124 is deposited by flash plating, for example with a thickness of less than 2 µm, on the exposed surface of the structure shown in Figure 5. For forming the flash plating layer 124, the structure of Figure 5 may be put in a chemical bath for depositing flash plating layer 124 by galvanic plating (including applying electric current). During flash plating, a current density may be set to a very low value or may even be minimized. This may promote a low line/space ratio of a trace of the readily manufactured component carrier 100 shown in Figure 8. The formation of the flash plating structure 124 prior to and in addition to a pattern plating structure 122 of multi-stage electroplating structure 110 (see Figure 7) simplifies handling, reduces the risk of delamination and thereby improves reliability.

Referring to **Figure 7****,** a dielectric pattern 128, for instance made of a dry film or another electrically insulating material, is formed on a part of the electroless metal layer 108. This may involve a pattern expose and develop process.

Thereafter, formation of multi-stage electroplating structure 110 on the electroless metal layer 108 is completed by forming pattern plating structure 122 by galvanic plating on the exposed surface of the flash plating structure 124 which is not covered by dielectric pattern 128. Formation of pattern plating structure 122 may be accomplished by galvanic plating and fills up the laser via 114 entirely (as shown) or partially (not shown). The process of forming pattern plating structure 122 takes longer than the process of forming flash plating structure 124. The galvanic plating process of forming pattern plating structure 122 is executed with a larger current density than the process of forming flash plating structure 124. When formation of the multi-stage electroplating structure 110 is completed, the dielectric pattern 128 extends through a top part of the multi-stage electroplating structure 110, i.e. is arranged on top of flash plating structure 124 and is surrounded by pattern plating structure 122. Hence, the multi-stage electroplating structure 110 may be formed by flash plating followed by selective pattern plating. Advantageously, the multi-stage electroplating structure 110 may be created in a horizontal plating line.

Referring to **Figure 8****,** the metal foil 104, the electroless metal layer 108 and the multi-stage electroplating structure 110 may then be patterned together for forming opening 130 using a lithographic dry film process. As a result, opening 130 is formed which extends through the multi-stage electroplating structure 110, the electroless metal layer 108 and the metal foil 104 for exposing a portion the base 106. This may involve a dry film strip and flash etch process. Consequently, in electrically conductive structure 126 may be formed in and/or around the laser via 114 and may be laterally delimited.

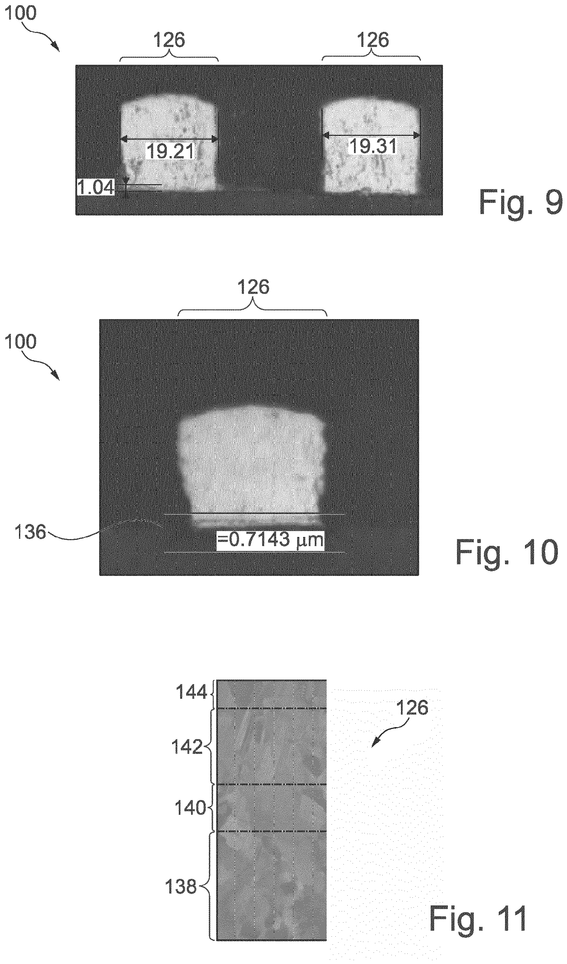

Figure 9 to Figure 13 show images with cross-sectional views of portions of component carriers 100 according to exemplary embodiments of the invention.

Referring to **Figure 9** and referring to **Figure 10****,** cross-sections of traces manufactured as electrically conductive structures 126 forming part of a component carrier 100 according to exemplary embodiments of the invention are shown.

Figure 9 shows two adjacent trace-type electrically conductive structures 126 being formed with a line/space ratio of about 20 µm/20 µm.

Figure 10 shows, with reference sign 136, a flash copper layer in the trace.

Referring to **Figure 11****,** a cross-sectional view of an electrically conductive structure 126 of a component carrier 100 according to an exemplary embodiment of the invention is illustrated, which has been manufactured with an mSAP process. As shown with reference sign 138, a target pad is visible. As shown with reference sign 140, an electroless copper layer can be distinguished. As shown with reference sign 142, a copper flash layer is present. As shown with reference sign 144, electroplating copper is provided.

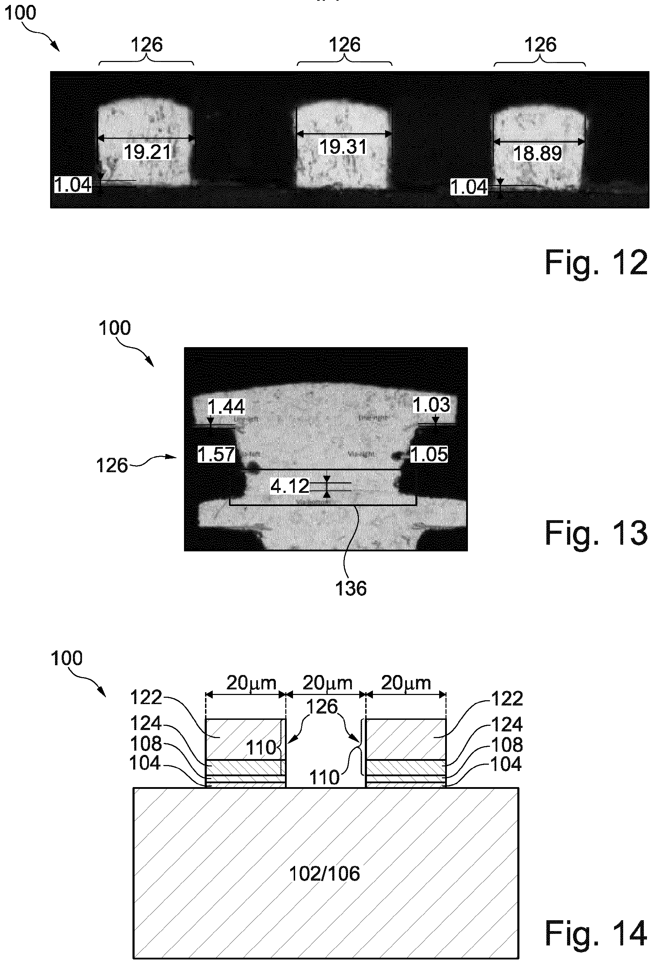

Referring to **Figure 12****,** cross-sections of traces manufactured as electrically conductive structure 126 forming part of a component carrier 100 according to an exemplary embodiment of the invention are shown. The line/space ratio is about 20 µm/20 µm.

Referring to **Figure 13****,** a cross-section of a trace manufactured as electrically conductive structure 126 forming part of a component carrier 100 according to an exemplary embodiment of the invention is shown. A flash copper line in the copper layer is shown with reference sign 136.

**Figure 14** illustrates a cross-sectional view of a component carrier 100 having traces as electrically conductive structures 126 with a small line/space ratio of 20 µm/20 µm according to an exemplary embodiment of the invention. The illustrated layer stack can be manufactured as described above.

As shown, electroless metal layer 108 may be utilized as high build electroless structure with medium deposition which can be produced at a horizontal plating line with no capacity impact.

Furthermore, it may be advantageously possible to utilize a metal foil 104 (preferably a copper foil) in the stack-up in order not to remove material formed by strike plating (i.e. flash plating structure 124, such as a flash copper plating structure) for better reliability. The copper foil in the stack-up may be used to avoid removing the strike plating structure: Strike plating or flash plating may require filling the via holes and plating the panel surface at the same time. In order to balance the plating thickness, the plating chemistry may contain ions for etching the copper plated on the surface at the same time when filling the vias. Without copper foil, this may be difficult or even impossible because the electroless layer may be too thin.

Advantageously, the illustrated traces may be formed by a combination of medium deposition of high build electroless with an ultra-thin copper foil and strike plating, which may lead to an optimum base copper thickness. Advantageously, this may not impact the 20 µm line shape after etching.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants are possible which use the solutions shown and the principle according to the invention even in the case of fundamentally different embodiments.

## Claims

1. A method of manufacturing a component carrier, wherein the method comprises:
covering a dielectric layer structure (102) by a metal foil (104);
forming an electroless metal layer (108) on the metal foil (104); and
forming a multi-stage electroplating structure (110) on the electroless metal layer (108).

2. The method according to claim 1, comprising at least one of the following features:
wherein the method comprises attaching the dielectric layer structure (102) covered by the metal foil (104) as a preformed double layer structure to a base (106);
wherein the method comprises forming the electroless metal layer (108) by a chemical process;
wherein the method comprises forming the multi-stage electroplating structure (110) by flash plating followed by pattern plating;
wherein the method comprises patterning the dielectric layer structure (102) covered by the metal foil (104), in particular to expose a base (106) on which the dielectric layer structure (102) is formed by forming a laser via (114) in the patterned dielectric layer structure (102) covered by the metal foil (104);
wherein the method comprises forming at least one of the electroless metal layer (108) and at least part of the multi-stage electroplating structure (110) in a horizontal plating line;
wherein the method comprises structuring the metal foil (104), the electroless metal layer (108) and the multi-stage electroplating structure (110) together, in particular using a lithographic dry film process;
wherein the method comprises forming a dielectric pattern (128) on a bottom-sided flash plating structure (124) of the multi-stage electroplating structure (110), and forming the dielectric pattern (128) to extend through a top-sided pattern plating structure (122) of the multi-stage electroplating structure (110).

3. A component carrier (100), which comprises:
a dielectric layer structure (102), covered by a metal foil (104);
an electroless metal layer (108) on the metal foil (104); and
a multi-stage electroplating structure (110) on the electroless metal layer (108).

4. The component carrier (100) according to claim 3,
wherein the dielectric layer structure (102), covered by the metal foil (104), is formed on only part of a base (106); and
wherein the electroless metal layer (108) is formed partially on the metal foil (104) and partially on the base (106).

5. The component carrier (100) according to claim 3 or 4, wherein the dielectric layer structure (102) and the metal foil (104) are patterned, in particular to expose a base (106) by a via (114) extending through the patterned dielectric layer structure (102) and the patterned metal foil (104).

6. The component carrier (100) according to claim 5, wherein the via (114) is at least partially filled by part of the electroless metal layer (108) and by part of the multi-stage electroplating structure (110).

7. The component carrier (100) according to claim 5 or 6, wherein the multi-stage electroplating structure (110) has a larger thickness (d1) in the via (114) compared to a smaller thickness (d2) above the dielectric layer structure (102).

8. The component carrier (100) according to any of claims 4 to 7, wherein the base (106) comprises a stack comprising at least one electrically conductive layer structure (118) and/or at least one electrically insulating layer structure (120).

9. The component carrier (100) according to any of claims 3 to 8, wherein the metal foil (104) has a thickness (d3) of less than 5 µm, in particular of not more than 3 µm.

10. The component carrier (100) according to any of claims 3 to 9, wherein the electroless metal layer (108) has a thickness (d4) of not more than 2 µm, in particular a thickness in a range from 1 µm to 1.5 µm.

11. The component carrier (100) according to any of claims 3 to 10, wherein the multi-stage electroplating structure (110) has a maximum thickness (d1) of at least 10 µm, in particular of at least 20 µm.

12. The component carrier (100) according to any of claims 3 to 11, wherein a pattern plating structure (122) of the multi-stage electroplating structure (110) has a thickness (d5) of at least 5 times of a thickness (d6) of a flash plating structure (124) of the multi-stage electroplating structure (110).

13. The component carrier (100) according to any of claims 3 to 12, wherein the metal foil (104), the electroless metal layer (108) and the multi-stage electroplating structure (110) form an electrically conductive structure (126) with a line/space ratio of not more than 20 µm/20 µm, in particular of not more than 15 µm/15 µm.

14. The component carrier (100) according to claim 13, wherein the electrically conductive structure (126) is a trace.

15. The component carrier (100) according to claim 13 or 14, wherein the electrically conductive structure (126) is free of an undercut.
